# EUROPEAN PATENT APPLICATION

(11) **EP 4 682 911 A1**
(43) Date of publication of application: **21.01.2026**
(21) Application number: 25165784.7
(22) Date of filing: 24.03.2025
(51) Int. Cl.: H01B 11/10, H05K 9/00, H01B 7/42

(54) **ELECTRICAL COMPONENT AND SHIELD ASSEMBLY**

(30) Priority: 19.07.2024 PL 44927524
(71) Applicant: GE Aviation Systems LLC, Grand Rapids, MI 49512 (US); GE Aerospace Poland Sp. z o.o., 02-256 Warsaw (PL)
(72) Inventor: YI, Xuan, Grand Rapids, 49512 (US); LI, Cong, Grand Rapids, 49512 (US); HUA, Yihe, Grand Rapids, 49512 (US); YOUNSI, Karim, Grand Rapids, 49512 (US); XIONG, Han, Grand Rapids, 49512 (US); HANCZEWSKI, Pawel Piotr, 02-256 Warsaw (PL)
(74) Representative: Openshaw & Co.

(57) **Abstract**

An electrical component (100) and shield assembly can include a set of conductors (120), with the shield assembly having a body (131) at least partially encircling the set of conductors (120). The shield assembly can include a first shield layer (150) radially spaced from a second shield layer (170). The first shield layer (150) can include a magnetic material. The second shield layer (170) can an electrically-conductive material.

## Description

### TECHNICAL FIELD

This disclosure generally relates to electrical components, and more specifically to shielding of such components.

### BACKGROUND

Electric machines, including motors or generators, can be used to supply or convert power for a variety of applications. In an aircraft environment, a single electric machine may include a combination of operational modes wherein, in some examples, a motor mode of the electric machine is used for starting an aircraft engine, and a generator mode of the electric machine is used for supplying electrical power to aircraft systems. Electric machines can additionally be used for driving other portions of the aircraft engine, such as a forward fan, propeller, or the like. Regardless of the number or type of modes that may be provided, electric machines typically include a stator and a rotor each having corresponding windings, wherein the rotor is driven to rotate relative to the stator for induction of current in the rotor or stator windings. For instance, a turbine engine may drive rotation for a generator to produce an electrical power output, or a stator may drive rotation for a motor to produce a rotational power output.

In certain contexts, a generator may be used for high-voltage power output or power distribution, such as for direct-current (DC) or alternating-current (AC) power applications. Conductive components of such systems including wiring, cabling, windings, or the like can experience electromagnetic interference or losses during operation.

### BRIEF DESCRIPTION OF THE DRAWINGS

A full and enabling disclosure of the present description, including the best mode thereof, directed to one of ordinary skill in the art, is set forth in the specification, which makes reference to the appended Figures, in which:
FIG. 1 is a schematic perspective view of a turbine engine having an electrical machine in the form of a generator in accordance with various aspects described herein.
FIG. 2 is a schematic perspective view of the generator of FIG. 1 and illustrating an electrical component in accordance with various aspects described herein.
FIG. 3 is a cross-sectional view of the generator of FIG. 2 along line III-III and illustrating additional details of the generator.
FIG. 4 is a partially-exploded side view of the electrical component of FIG. 1 and illustrating a shield assembly in accordance with various aspects described herein.
FIG. 5 is a schematic cross-sectional view of the electrical component of FIG. 4 along line V-V.
FIG. 6 is a schematic cross-sectional view, similar to FIG. 5, of another electrical component having another shield assembly in accordance with various aspects described herein.
FIG. 7 is a schematic cross-sectional view, similar to FIG. 5, of another electrical component having another shield assembly in accordance with various aspects described herein.
FIG. 8 is a schematic cross-sectional view, similar to FIG. 5, of another electrical component having another shield assembly in accordance with various aspects described herein.
FIG. 9 is a schematic cross-sectional view, similar to FIG. 5, of another electrical component having another shield assembly in accordance with various aspects described herein.
FIG. 10 is a flowchart illustrated a method of forming a shield assembly in accordance with various aspects described herein.

### DETAILED DESCRIPTION

The present disclosure generally relates to an electrical component and a shield assembly. The described aspects of the present disclosure will be described in one exemplary context of a generator in a turbine engine environment. However, the disclosure is not so limited, and aspects of the disclosure can have general applicability in other electrical components or environments. For example, aspects of the disclosure can be applicable to generators, motors, starter/generators, transformers, inductors, wiring, cables, power generation systems, power distribution systems, or power transmission systems. Aspects of the disclosure can also be used to provide benefits in industrial, commercial, or residential applications.

In some implementations, power systems can provide high-voltage AC (HVAC) power to meet large power demands. Components of such systems, including power cables, power converters, power distribution units, or the like, can therefore experience large current loads during operation. HVAC power systems can also be implemented in a limited-space or power-dense arrangement, where system components operate in close proximity to one another. It can be important to shield power system components from electromagnetic interference (EMI) during operation. As discussed herein, "electromagnetic interference," "EMI," or "interference" will be used interchangeably and can refer to any electromagnetic wave, or to any disturbance corresponding to an electromagnetic wave, including power fluctuations, noise, cross-talk, signal interruptions, error rate increases, or the like. EMI as discussed herein can encounter an electrical component in some examples, or can be emitted by an electrical component in some examples. EMI as discussed herein also includes disturbances originating from electromagnetic waves in any portion of the electromagnetic spectrum, including radio frequencies or microwave frequencies in non-limiting examples. Furthermore, EMI as discussed herein can include a transient disturbance or pulse, a repetitive disturbance or pulse train, or continuous-wave interference.

Electronic components are known to include insulation and/or shielding elements to reduce EMI. For instance, in an electrical cable with power-carrying wires, a typical shielding arrangement includes surrounding the wires with one or more electrically-conductive shielding layers, such as a metallic braid or foil wrap, and grounding the layers at each end of the cable. Such shielding layers can reduce EMI by way of current induction within the layers, including damping emissions from the power-carrying wires as well as damping external emissions encountering the cable.

For high-power components carrying large current loads, including HVAC system components, the shielding layers can experience large eddy currents leading to large thermal loads during operation, which can also lead to a reduction in shielding performance. Cooling systems, additional shielding layers, thicker shielding layers, or the like can be utilized to reduce the thermal load during operation. However, such additions can add complexity, weight, and cost to the component.

Aspects of the disclosure provide for an electrical component and shield assembly having a magnetic shield layer and an electrically-conductive shield layer, providing for a reduction of induced currents and thermal load in the shielding layer. Aspects of the disclosure additionally provide for a magnetic layer with magnetic powder suspended in a resin, which provides for a reduced material density compare to conventional shield layers, leading to reductions in overall weight and cost of the shield assembly.

As used herein, the terms "axial" or "axially" will refer to a dimension along a longitudinal axis of a component. The terms "radial" or "radially" as used herein will refer to a dimension extending orthogonally from the longitudinal axis. In addition, the use of the terms "proximal" or "proximally," either by themselves or in conjunction with the terms "radial" or "radially," will refer to moving in a direction toward the center longitudinal axis, or a component being relatively closer to the center longitudinal axis as compared to another component. In addition, as used herein, the terms "circumferential" and "circumferentially" refer to directions and orientations that extend arcuately about the centerline of the turbine engine.

As used herein, the terms "first," "second," "third," "fourth," or the like can be used interchangeably to distinguish one component from another and are not intended to signify location or importance of the individual components. In addition, while "a set of" various elements will be described, it will be understood that "a set" can include any number of the respective elements, including only one element.

Here and throughout the specification and claims, range limitations are combined, and interchanged. Such ranges are identified and include all the sub-ranges contained therein unless context or language indicates otherwise. For example, all ranges disclosed herein are inclusive of the endpoints, and the endpoints are independently combinable with each other.

All directional references (e.g., radial, axial, upper, lower, upward, downward, left, right, lateral, front, back, top, bottom, above, below, vertical, horizontal, clockwise, counterclockwise) are only used for identification purposes to aid the reader's understanding of the disclosure, and do not create limitations, particularly as to the position, orientation, or use thereof. Connection references (e.g., attached, coupled, connected, and joined) are to be construed broadly and can include intermediate members between a collection of elements and relative movement between elements unless otherwise indicated. As such, connection references do not necessarily infer that two elements are directly connected and in fixed relation to each other.

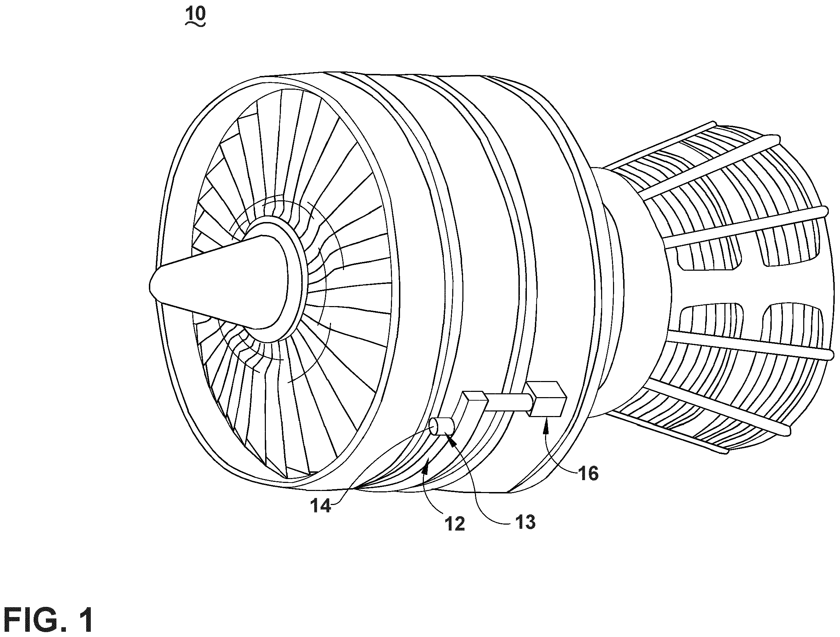

Referring now to FIG. 1, an exemplary turbine engine 10 is illustrated. For instance, the turbine engine 10 can be a turbofan, turboprop, or turboshaft engine. The type and specifics of the turbine engine 10 are not germane to the disclosure and will not be described further herein.

The turbine engine 10 can include an accessory gear box (AGB) 12. The AGB 12 can be operably coupled to a rotatable shaft of the gas turbine engine 10. In the example shown, the AGB 12 is operably coupled to a mechanical power take-off 16. The turbine engine 10 can additionally include an electric machine 13. In the illustrated example, the electric machine 13 is in the form of a generator 14 though this need not be the case. The electric machine 13 can also include an electric motor, a starter/generator, or the like. Furthermore, a plurality of electric machines 13 can be provided.

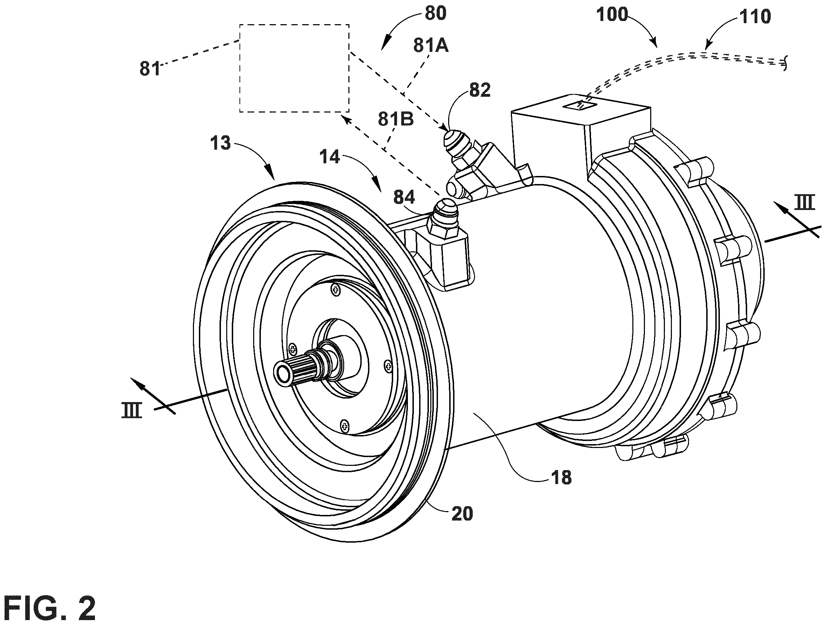

FIG. 2 illustrates additional details of the generator 14. The generator 14 can include a housing 18 and a clamping interface 20. For instance, the clamping interface 20 can be used to secure the generator 14 to the AGB 12 of FIG. 1.

An exemplary electrical component 100 can be operably coupled with the generator 14 as shown. It is contemplated that the electrical component 100 can be incorporated with the generator 14 in some implementations, or be a distinct component electrically coupled to the generator 14 in some implementations. In the illustrated example, the electrical component 100 includes an electrical cable 110 (also referred to herein as "cable 110") coupled to the generator 14, such as by a power output port or connector, for supplying power to various loads. It should be understood that the electrical component 100 can include any suitable component for generating, providing, transmitting, or storing electrical power. For instance, in one non-limiting example, the electrical component 100 can include a set of electrical connections on the exterior of the generator 14, enabling the transfer of electrical power to and from the generator 14. In another non-limiting example, the electrical component 100 can include a set of rotor windings or stator windings within the generator 14. In still another non-limiting example where the turbine engine 10 (FIG. 1) is provided on an aircraft, the electrical component 100 can include one or more cables for connecting the generator 14 to a power distribution node of the aircraft, enabling power supply to various items within the aircraft.

The generator 14 can include a cooling system 80 for cooling or dissipating heat generated by components of the generator 14 or by components proximate to the generator 14, including the gas turbine engine 10 of FIG. 1. In the exemplary implementation shown, the cooling system 80 includes a liquid coolant, such as oil in one example. It is contemplated that the cooling system 80 can utilize any cooling fluid including air, liquid, or a combination thereof.

The cooling system 80 includes a coolant source 81 (shown schematically in dashed line) for storing, providing, or circulating coolant. A coolant supply path 81A and a coolant return path 81B are shown fluidly coupling the coolant source 81 to the generator 14. It is contemplated that any or all of the coolant source 81, the coolant supply path 81A, or the coolant return path 81B can be located within the generator 14 or externally of the generator 14.

The generator 14 includes a fluid inlet port 82 and a fluid outlet port 84 fluidly coupled to the respective coolant supply path 81A and the coolant return path 81B. The fluid inlet and outlet ports 82, 84 can be utilized for controlling the supply of coolant to the generator 14. For instance, in a non-limiting example the cooling fluid inlet and outlet ports 82, 84 can be utilized for cooling portions of a rotor or stator within the generator 14. Furthermore, while a single fluid inlet port 82 and fluid outlet port 84 are shown, it is contemplated that multiple fluid inlet ports or outlet ports can be provided.

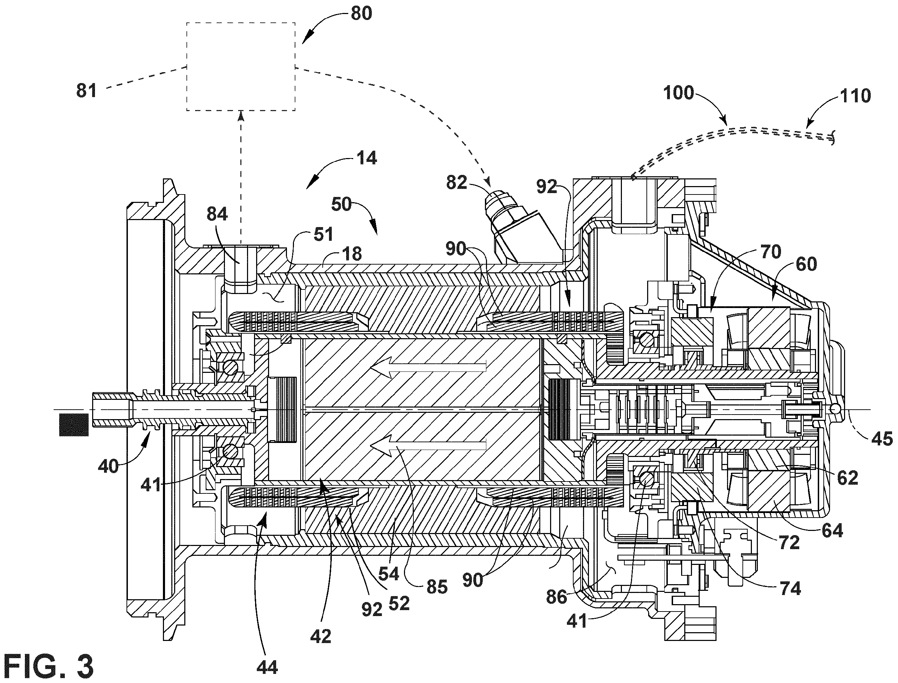

Referring now to FIG. 3, a cross-sectional view of the generator 14 is shown along line III-III of FIG. 2. The electrical component 100, e.g. the electrical cable 110, is also shown for reference.

A drive shaft 40 is located within the generator 14 and is the primary structure for supporting a variety of components. The drive shaft 40 can have a diameter that is constant or variable along its length. The drive shaft 40 can be supported by spaced bearings 41. The drive shaft 40 can be configured to rotate about a rotational axis 45 relative to the housing 18 as shown.

The generator 14 can include a rotor portion 42 and a stator portion 44. As used herein, "rotor portion" will refer to a portion or component that is operably coupled to the drive shaft 40 and rotatable with respect to the housing 18, and "stator portion" will refer to a portion or component that is fixed relative to the housing 18.

An electric machine 50 (also referred to herein as a "main machine 50") can be provided and include a main machine rotor 52 and a main machine stator 54. It is contemplated that the electric machine 50 can include a synchronous generator, an asynchronous generator, a Pulse-Width Modulation (PWM) driven electric machine, a 50/60Hz sine wave machine, or the like. The main machine 50 can be housed within a main machine cavity 51 as shown. In addition, in the non-limiting example shown an exciter 60 and a permanent magnet generator (PMG) 70 are provided. The exciter 60 can include an exciter rotor 62 and an exciter stator 64. The PMG 70 can include a PMG rotor 72 and a PMG stator 74.

The main machine rotor 52 can be disposed on and co-rotate with the drive shaft 40. Optionally, the exciter rotor 62 or the PMG rotor 72 can also be disposed on and co-rotate with the drive shaft 40. The main machine stator 54, and optionally the exciter stator 64 or the PMG stator 74, can be coupled or mounted to the housing 18. In this manner, the main machine rotor 52, exciter rotor 62, and PMG rotor 72 can collectively form at least part of the rotor portion 42, and the main machine stator 54, exciter stator 64, and PMG stator 74 can collectively form at least part of the stator portion 44.

At least one of the rotor portion 42 or the stator portion 44 can include poles formed by a core with a post and wire wound about the post to form a winding, with the winding having at least one end turn or end winding. In the illustrated example, some exemplary stator windings 90 are shown with corresponding end turns 92. Additionally, or alternatively, at least one of the main machine rotor 52, exciter rotor 62, or PMG rotor 72 can include a set of magnetic materials instead of the winding. Such magnetic materials can include a permanent magnet in a non-limiting example.

The stator portion 44 can define an interior through which the drive shaft 40 extends and rotates. It is understood that rotation of the rotor portion 42 relative to the stator portion 44 can generate a flow of current within components of the stator portion 44. In this manner, rotation of the rotor portion 42 can generate electrical power which can be supplied to the cable 110.

As described above, the cooling system 80 can distribute or circulate coolant from the coolant source 81 by way of one or more passages, outlets, or the like within the generator 14 during operation. For instance, in the non-limiting example shown, the cooling system 80 further includes a cooling fluid reservoir 86 and various cooling passages within the generator 14. The drive shaft 40 can additionally include one or more channels or paths for coolant flow or distribution. One exemplary fluid coolant flow 85 is shown for distributing coolant to any or all of the main machine rotor 52, the exciter rotor 62, or the PMG rotor 72. In this manner, coolant from the coolant source 81 can be used to dissipate heat generated by the electrical and mechanical functions of the generator 14. In some implementations wherein the coolant source 81 includes oil, the cooling system 80 can additionally provide for lubrication of components within the generator 14 during operation. It should be understood that the generator 14 can include additional components or accessories not shown in FIG. 3. For instance, the generator 14 can further include a liquid coolant pump, a fluid compressor, a hydraulic pump, or the like.

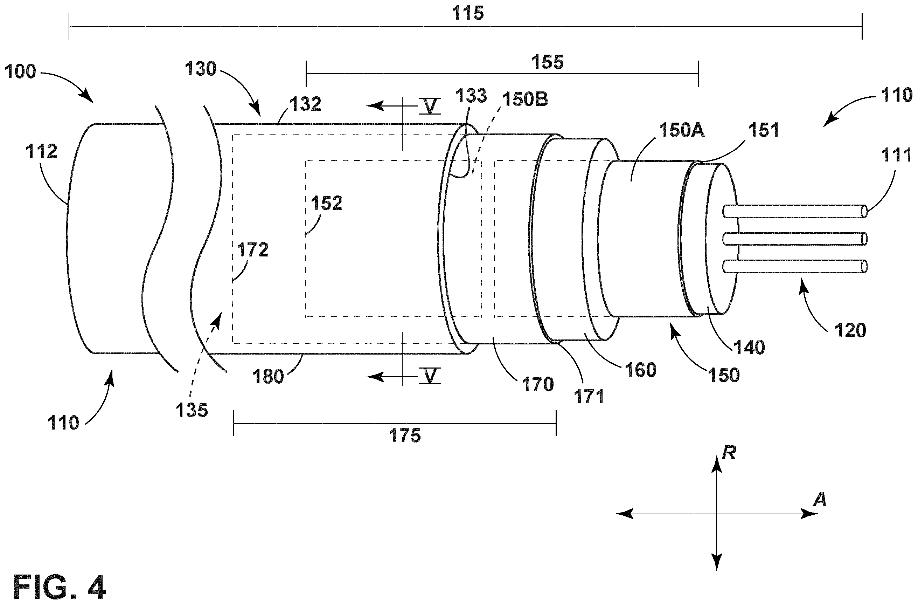

Referring now to FIG. 4, the cable 110 is shown in isolation. The cable 110 extends between a first cable end 111 and a second cable end 112, and defines a cable length 115 between the first and second cable ends 111, 112 as shown. For visual clarity, the cable 110 is illustrated with break lines. It should be understood that the cable length 115 can have any suitable value, including 0.5-1 m, or 1-10 m, or greater than 10 m, in non-limiting examples.

The cable 110 can include a set of electrical conductors (also referred to herein as "set of conductors") 120 in the form of wires extending along an axial direction A as shown. A radial direction R orthogonal to the axial direction A is also illustrated for reference.

In the non-limiting implementation shown, the set of conductors 120 includes three radially-spaced, single-strand conductors that are configured to provide three-phase AC power. It will be understood that the set of conductors 120 can include any number of conductors, including a single conductor, or two or more. Each conductor in the set of conductors 120 can also have any number of strands, including a single strand, or two or more strands. The set of conductors 120 can also be distributed in any suitable manner, including two or more abutting conductors, or two or more conductors spaced from one another, in non-limiting examples. The set of conductors 120 can also be configured to provide any suitable power, including AC power or DC power, to meet power needs.

A shield assembly 130 can be provided with the cable 110. In some implementations, the cable 110 can be formed integrally with the shield assembly 130 and the set of conductors 120 as a singular component. In other implementations, the shield assembly 130 can be a separate or discrete component configured to couple to, snap onto, slide over, encircle, or otherwise receive the set of conductors 120. For instance, the shield assembly 130 can be configured for assembly onto an existing cable for enhanced EMI shielding. In addition, while the shield assembly 130 is generally illustrated in the form of an elongated sheath or jacket, it will be understood that aspects of the disclosure are not so limited and the shield assembly 130 can have any suitable geometric profile or form.

For the purposes of visual clarity, portions of the shield assembly 130 are illustrated as being axially offset from one another and from the set of conductors 120 in a partially-exploded or telescoping view. It should also be understood that the shield assembly 130 can have any suitable cross-sectional geometric profile, including oval, circular, hexagonal, symmetric, asymmetric, irregular, or the like.

The shield assembly 130 includes a body 131 with an exterior surface 132 opposite an interior surface 133. In the non-limiting example shown, the body 131 includes an outer insulation layer 180 defining the exterior and interior surfaces 132, 133 though this need not be the case. It is also contemplated that the body 131 can include additional layers not shown in FIG. 4, including an outer shell, fabric wrap, fastener, or the like. Such additional layers can be coupled to any portion of the outer insulation layer. Such additional layers can also at least partially define the exterior surface 132 of the body 131.

The interior surface 133 bounds an interior 135 configured to receive the set of conductors 120. For instance, the shield assembly 130 can at least partially encircle the set of conductors 120. As shown, the shield assembly 130 includes a first insulation layer 140 disposed within the interior 135. The first insulation layer 140 can at least partially surround or envelop the set of conductors 120. The first insulation layer 140 can also include any suitable insulating material including, but not limited to, mica insulation or tape, polymer film, composite insulation, or the like. It is further contemplated that the first insulation layer 140 can be impregnated or supported by other materials such as, but not limited to, an epoxy resin or a fiberglass weave.

A first shield layer 150 is also disposed within the interior 135. The first shield layer 150 can at least partially surround the first insulation layer 140. The first shield layer 150 can be radially spaced from the set of conductors 120, including by way of the first insulation layer 140. The first shield layer 150 can be a magnetic shield layer and include a magnetic material. More specifically, the first shield layer 150 can include magnetic particles, such as magnetic powder, suspended in a resin. Any suitable magnetic particles and resin can be utilized. In some implementations, the resin can be an epoxy resin and the magnetic particles can include ferrite powder, permalloy powder, or high flux powder, in non-limiting examples. The magnetic particles can have a low relative magnetic permeability *µ*ᵣ, including between 1-500, or between 20-300, or between 50-200, in non-limiting examples. The magnetic particles can also have a high saturation level, including between 0.5-3 T, or between 1-2 T, in non-limiting examples.

A second insulation layer 160 can be provided surrounding the first shield layer 150. The second insulation layer 160 can include any suitable insulating material including, but not limited to, mica insulation or tape, polymer film, composite insulation, or the like. It is further contemplated that the second insulation layer 160 can be impregnated or supported by other materials such as, but not limited to, an epoxy resin or a fiberglass weave. In some implementations, the first and second insulation layers 140, 160 can be separate or discrete layers. In some implementations, the first and second insulation layers 140, 160 can form part of a common insulation pack through which the first shield layer 150 and the set of conductors 120 extends.

A second shield layer 170 is additionally disposed in the interior 135. The second shield layer 170 can at least partially surround the second insulation layer 160. The second shield layer 170 can be radially spaced from the first shield layer 150, including by way of the second insulation layer 160. The second shield layer 170 can include an electrically-conductive material including, but not limited to, a conductive coating, a conductive paint, a conductive tape, a metallic foil, a metallic braid, a metallic spiral wrap, nickel coated polymers, copper coated polymers, fiberglass, or the like. In some implementations, the outer insulation layer 180 can at least partially surround the second shield layer 170 though this need not be the case.

The first and second shield layers 150, 170 can each extend from a respective first end 151, 171 to a respective second end 152, 172. A first axial length 155 is defined between the first end 151 and the second end 152 of the first shield layer 150. A second axial length 175 is defined between the first end 171 and the second end 172 of the second shield layer 170.

In some implementations, either or both of the first or second shield layers 150, 170 can include a set of discrete portions or segments. For instance, in the illustrated example the first shield layer 150 includes a first shield segment 150A defining the first end 151 and a second shield segment 150B defining the second end 152, and the second shield layer 170 includes a single, non-segmented layer, though this need not be the case. Any suitable number of shield segments can be provided. Additionally, as shown the first and second shield segments 150A, 150B are axially spaced apart. In other implementations, the first and second shield segments 150A, 150B can abut one another. In still other implementations, the first and second shield segments 150A, 150B can be radially spaced from one another. In this manner, the first shield layer 150 or the second shield layer 170 can include multiple layer segments or a single, non-segmented layer within the cable 110.

It is also contemplated that the first or second axial lengths 155, 175 can be the same or different from one another. As shown, the first axial length 155 is less than the second axial length 175 though this need not be the case. Furthermore, the first axial length 155 or the second axial length 175 can also be the same or different compared to the cable length 115. In certain implementations, either or both of the first axial length 155 or the second axial length 175 can be between 20-100% of the cable length 115.

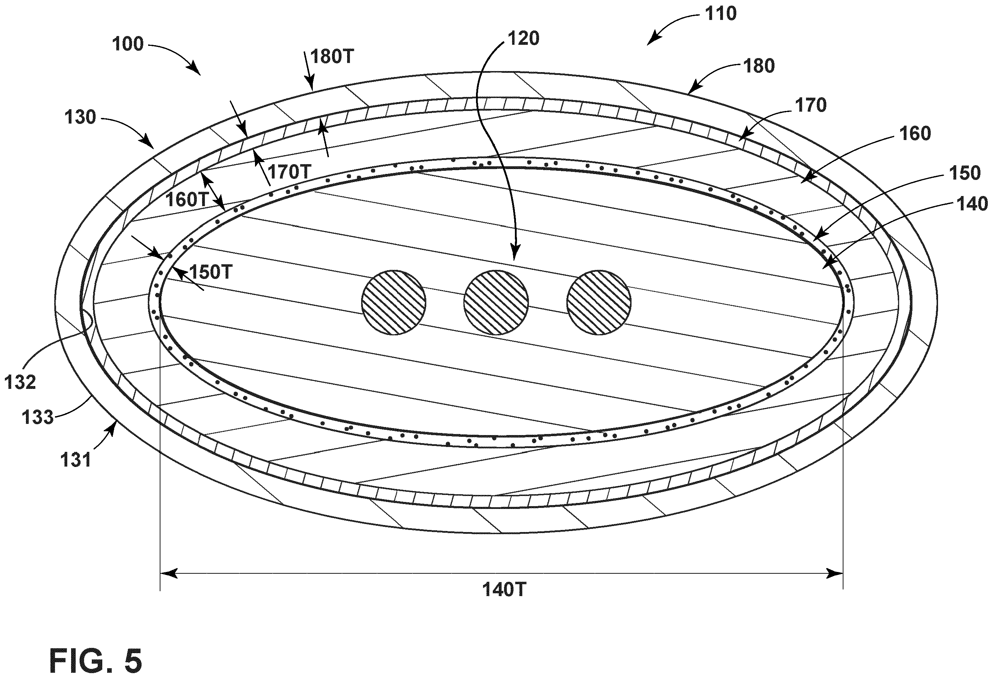

FIG. 5 illustrates a cross-sectional view of the cable 110 along line V-V of FIG. 4. In the illustrated example, the first insulation layer 140 separately contacts and envelops each conductor in the set of conductors 120, though this need not be the case. In some implementations, the first insulation layer 140 can encircle a perimeter about the entire set of conductors 120. One or more conductors in the set of conductors 120 can also be encircled by a separate insulating body, such as a plastic or polymeric sheath, a rubber tube, or the like. Such an insulating body can be enveloped or encircled by the first insulation layer 140 in the assembled cable 110 in some implementations. In addition, for visual clarity the cable 110 is illustrated with exaggerated spacing between the first shield layer 150 and the set of conductors 120. It will be understood that the cable 110 and components therein can have any relative spacing, proportions, or the like.

In addition, in the non-limiting example shown the first shield layer 150 fully surrounds the first insulation layer 140. In some implementations, the first shield layer 150 can be precured and applied over the first insulation layer 140. In other implementations, the first shield layer 150 can be formed and separately assembled over the first insulation layer 140.

The second insulation layer 160 can at least partially surround the first shield layer 150 as shown. The second shield layer 170 can at least partially surround the second insulation layer 160. In this manner, the second shield layer 170 can be radially spaced from the first shield layer 150.

In addition, the outer insulation layer 180 can at least partially surround the second shield layer 170. In the non-limiting example shown, the outer insulation layer 180 abuts or is coupled to the second shield layer 170.

It is contemplated that a single material layer or multiple material layers can be utilized for any of the first insulation layer 140, the first shield layer 150, the second insulation layer 160, or the second shield layer 170. In one exemplary implementation, a material tape, such as a silicon carbide tape or an electrically insulative tape, can be wrapped to form one or more material layers for the first insulation layer 140 or the second insulation layer 160. In another implementation, the first shield layer 150 can be formed with sequentially-cured resin layers, with magnetic powder carried by at least some of the resin layers. In still another implementation, the second shield layer 170 can be formed as a single material layer, such as a braided-copper layer in one example.

Each of the layers 140, 150, 160, 170, 180 can have any suitable thickness. As shown, the first insulation layer 140, the first shield 150, the second insulation layer 160, the second shield 170, and the outer insulation layer 180 define a first insulation thickness 140T, a first shield thickness 150T, a second insulation thickness 160T, a second shield thickness 170T, and an outer insulation thickness 180T, respectively. The thicknesses 140T, 150T, 160T, 170T, 180T can have any suitable size. For instance, at least two of the thicknesses 140T, 150T, 160T, 170T, 180T can be the same in some implementations, or can be different in some implementations. Moreover, it is contemplated that any of the thicknesses 140T, 150T, 160T, 170T, 180T can vary in different portions of the cable 110, including varying along the axial direction A or the radial direction R. For instance, while the first insulation thickness 140T is illustrated as a maximum thickness, in certain implementations the first insulation thickness 140T can be defined as a minimum thickness, or an average thickness, of the first insulation layer 140.

With general reference to FIGS. 1-5, during operation of the cable 110, EMI can encounter the first and second shield layers 150, 170. The magnetic particles of the first shield layer 150 can at least partially surround or enclose the set of conductors 120. In this manner, the first shield layer 150 can provide flux shielding, flux shaping, or flux damping for the set of conductors 120. The first shield layer 150 can also minimize induced-current losses and hysteresis losses that may occur under high-frequency excitation. In particular, the suspended magnetic particles in the first shield layer 150 reduces the magnetic permeability and increases the magnetic saturation level in the first shield layer 150 compared to a solid ferromagnetic later. Losses in the second shield layer 170 can be reduced due to induced flux density reduction enclosed by the first shield layer 150, providing for improved performance of the cable 110. In this manner, the magnetic first shield layer 150 in use with the electrically-conductive second shield layer 170 can provide high shielding performance with low shielding losses, improving overall current density and efficiency in the cable 110.

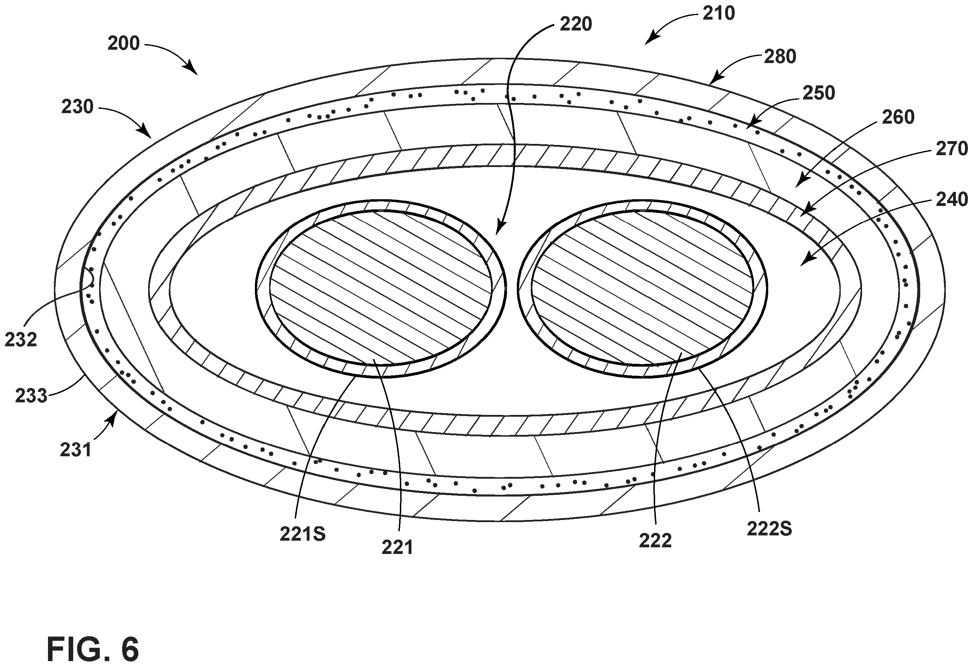

Referring now to FIG. 6, another electrical component 200 is illustrated. The electrical component 200 is similar to the electrical component 100. Therefore, like parts will be identified with like numerals increased by 100, with it being understood that the description of the like parts of the electrical component 100 applies to the electrical component 200, except where noted.

The electrical component 200 can include a cable 210, which can be an HVAC cable in some implementations. The electrical component 200 includes a set of conductors 220 and a shield assembly 230. The shield assembly 230 can include a body 231 with an exterior surface 232 opposite an interior surface 233. The body 231 can include a first insulation layer 240, a second insulation layer 260, and an outer insulation layer 280, as well as a first shield layer 250 and a second shield layer 270. The first shield layer 250 can be a magnetic shield layer and include a magnetic material, such as magnetic particles suspended in a resin. The second shield layer 270 can include an electrically-conductive material.

One difference compared to the electrical component 100 is that the first insulation layer 240 can be an air gap within the cable 210 as shown. Such an air gap can provide for increased flexibility of the cable 210. Another difference compared to the electrical component 100 is that the set of conductors 220 includes a first conductor 221 and a second conductor 222 in the non-limiting example shown. Any number of conductors can be provided in the set of conductors 220, including a single conductor, or three or more conductors. Another difference is that the first conductor 221 and the second conductor 222 are illustrated as wrapped with a respective first sheath 221S and second sheath 222S. Furthermore, the first conductor 221 and the second conductor 222 are shown as single-strand conductors in the illustrated example. It is contemplated that either or both of the first conductor 221 or the second conductor 222 can have multiple strands in some implementations. In such a case, the multiple strands can be exposed to one another, e.g. in a twisted-strand arrangement. Such multiple strands can also be insulated from one another with separate sheaths provided for at least some of the strands within the first or second conductor 221, 222.

Still another difference compared to the electrical component 100 is that the first shield layer 250 is coupled to the interior surface 232 of the body 231. For example, the first shield layer 250 can be coupled directly to the outer insulation layer 280. Another difference is that the second shield layer 270 is positioned radially inward from the first shield layer 250. For example, the second shield layer 270 can be arranged between the first and second insulation layers 240, 260 as shown. In this manner, the positioning of the magnetic first shield layer 250 radially outward of the second shield layer 270 can provide for enhanced shielding against external EMI for the set of conductors 220.

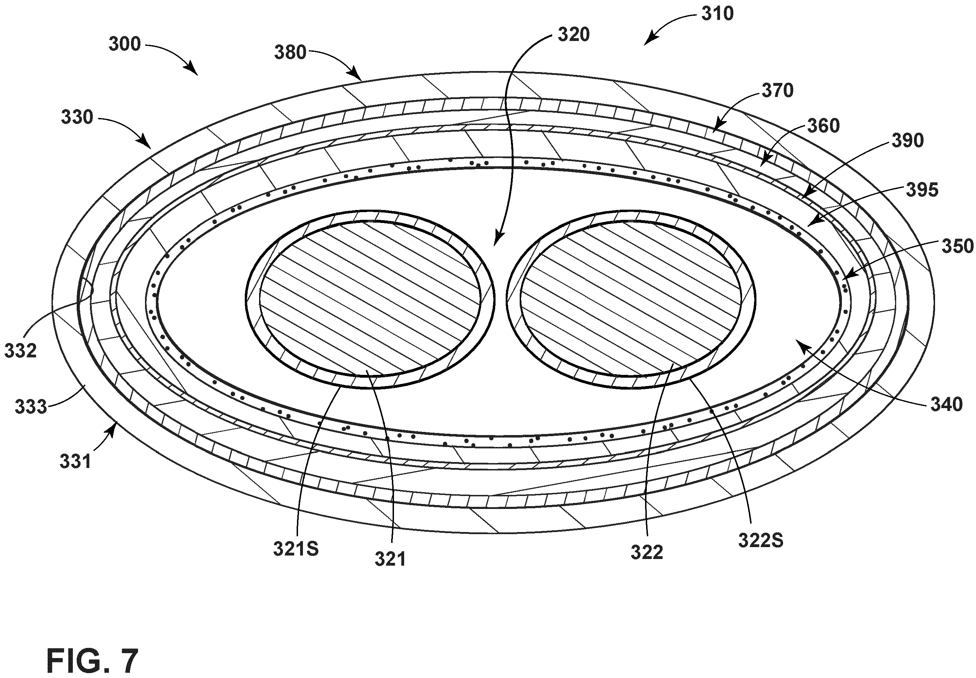

Turning to FIG. 7, another electrical component 300 is illustrated. The electrical component 300 is similar to the electrical components 100, 200. Therefore, like parts will be identified with like numerals further increased by 100, with it being understood that the description of the like parts of the electrical component 100, 200 applies to the electrical component 300, except where noted.

The electrical component 300 can include a cable 310, which can be an HVAC cable in some implementations. The electrical component 300 includes a set of conductors 320 and a shield assembly 330. The shield assembly 330 can include a body 331 with an exterior surface 332 opposite an interior surface 333. The body 331 can include a first insulation layer 340, a second insulation layer 360, and an outer insulation layer 380, as well as a first shield layer 350 and a second shield layer 370. The first shield layer 350 can be a magnetic shield layer and include a magnetic material, such as magnetic particles suspended in a resin. The second shield layer 370 can include an electrically-conductive material. In addition, the first insulation layer 340 can be an air gap within the cable 310 as shown.

In the non-limiting example shown, the set of conductors 320 includes a first conductor 321 and a second conductor 322, although any number of conductors can be provided. The first conductor 321 and the second conductor 322 are illustrated as wrapped with a respective first sheath 321S and second sheath 322S. Furthermore, the first conductor 321 and the second conductor 322 are shown as single-strand conductors in the illustrated example. It is contemplated that either or both of the first conductor 321 or the second conductor 322 can have multiple strands in some implementations.

One difference compared to the electrical components 100, 200 is that a third shield layer 390 and a third insulation layer 395 can be provided in the shield assembly 330. The third shield layer 390 can include an additional electrically-conductive material including, but not limited to, a conductive coating, a conductive paint, a conductive tape, a metallic foil, a metallic braid, a metallic spiral wrap, nickel coated polymers, copper coated polymers, fiberglass, or the like. In some implementations, the electrically-conductive material of the second shield layer 370 can be the same as the additional electrically-conductive material of the third shield layer 390. In other implementations, the electrically-conductive material can include a different form of the additional electrically-conductive material, such as copper foil and braided copper in one example. In still other implementations, the second shield layer 370 and the third shield layer 390 can include different materials, including materials with different electrical conductivities.

The third insulation layer 395 can be similar to the first insulation layer 340 or the second insulation layer 360. In some implementations, the same material can be used for each of the first, second, and third insulation layers 340, 360, 395. In some implementations, differing materials can be used for at least two of the first, second, and third insulation layers 340, 360, 395.

Additionally, in the non-limiting example shown, the third shield layer 390 is positioned radially between the first shield layer 350 and the second shield layer 370. It is contemplated that the third shield layer 390 can be positioned radially outward from each of the first shield layer 350 and the second shield layer 370, or radially inward from each of the first shield layer 350 and the second shield layer 370, in non-limiting examples. In this manner, the third shield layer 390 can provide for additional shielding of EMI from external sources as well as from eddy currents or internal EMI within the cable 310.

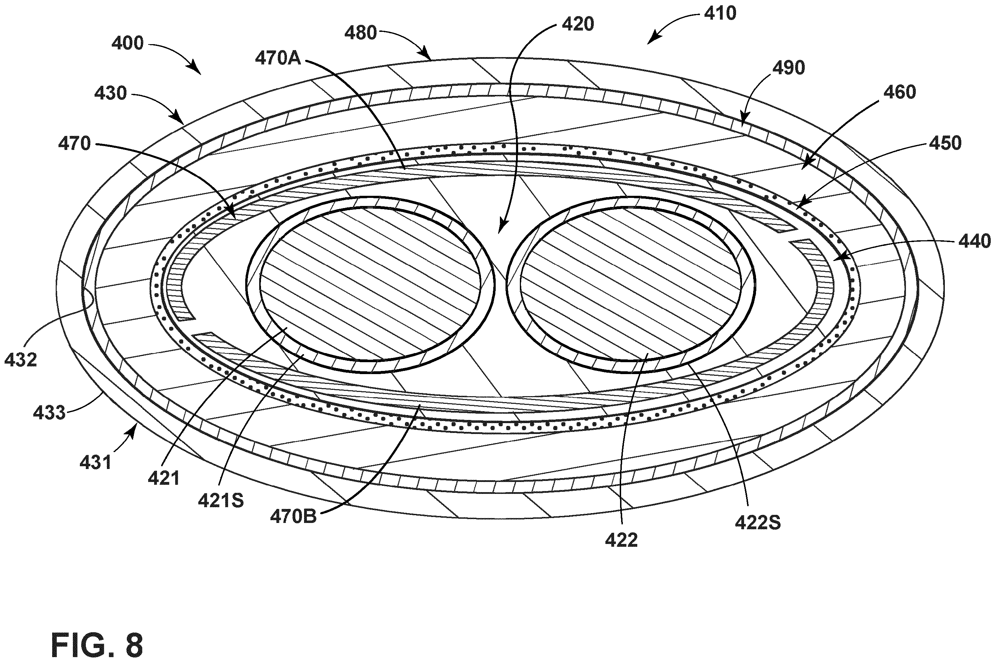

Turning to FIG. 8, another electrical component 400 is illustrated. The electrical component 400 is similar to the electrical components 100, 200, 300. Therefore, like parts will be identified with like numerals further increased by 100, with it being understood that the description of the like parts of the electrical component 100, 200, 300 applies to the electrical component 400, except where noted.

The electrical component 400 can include a cable 410, which can be an HVAC cable in some implementations. The electrical component 400 includes a set of conductors 420 and a shield assembly 430. The shield assembly 430 can include a body 431 with an exterior surface 432 opposite an interior surface 433. The body 431 can include a first insulation layer 440, a second insulation layer 460, and an outer insulation layer 480, as well as a first shield layer 450 and a second shield layer 470. The first shield layer 450 can be a magnetic shield layer and include a magnetic material, such as magnetic particles suspended in a resin. The second shield layer 370 can include an electrically-conductive material.

In the non-limiting example shown, the set of conductors 420 includes a first conductor 421 and a second conductor 422, although any number of conductors can be provided. The first conductor 421 and the second conductor 422 are illustrated as wrapped with a respective first sheath 421S and second sheath 422S. Furthermore, the first conductor 421 and the second conductor 422 are shown as single-strand conductors in the illustrated example. It is contemplated that either or both of the first conductor 421 or the second conductor 422 can have multiple strands in some implementations.

One difference compared to the electrical components 100, 200, 300 is that the first shield layer 450 can be positioned radially between the second and third shield layers 470, 490. Another difference is that the second shield layer 470 can include multiple shield segments. As shown, the second shield layer 470 includes a first shield segment 470A and a second shield segment 470B. Any number of shield segments can be provided. In addition, as shown the first and second shield segments 470A, 470B are spaced apart and distributed circumferentially about the set of conductors 420. In other implementations, shield segments can be distributed axially along the set of conductors 420.

Still another difference is that the second shield layer 470 can extend through the first insulation layer 440. More specifically, in the non-limiting example shown the first insulation layer 440 envelops or surround each of the first and second shield segments 470A, 470. The first insulation layer 440 can fill the space between the first and second shield layers 450, 470. In this manner, a number of discrete insulation layers can be reduced in the cable 410, which can lead to a reduction in assembly complexity and cost.

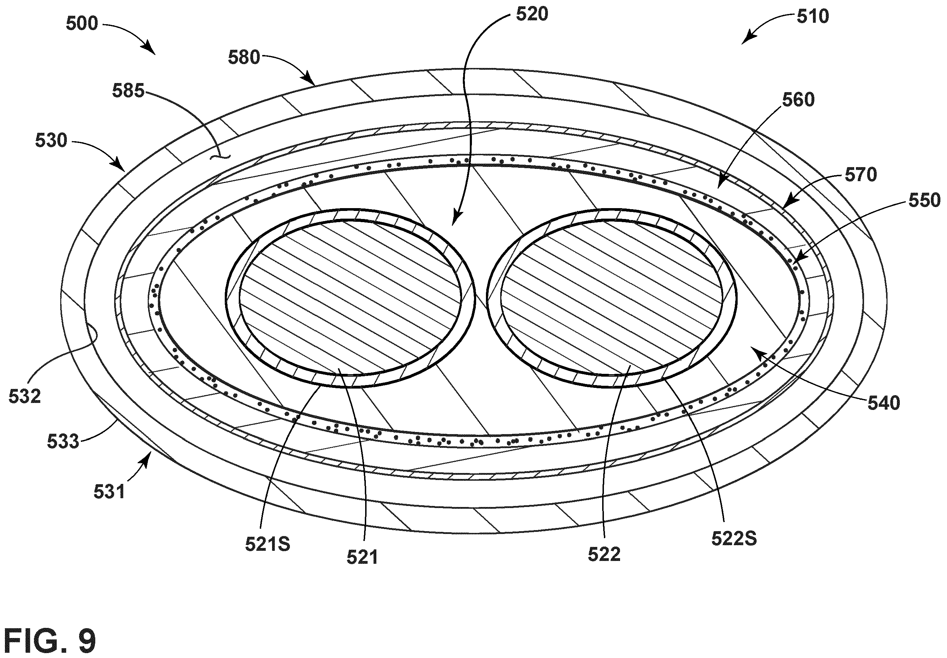

Referring now to FIG. 9, another electrical component 500 is illustrated. The electrical component 500 is similar to the electrical components 100, 200, 300, 400. Therefore, like parts will be identified with like numerals further increased by 100, with it being understood that the description of the like parts of the electrical component 100, 200, 300, 400 applies to the electrical component 500, except where noted.

The electrical component 500 can include a cable 510, which can be an HVAC cable in some implementations. The electrical component 500 includes a set of conductors 520 and a shield assembly 530. The shield assembly 530 can include a body 531 with an exterior surface 532 opposite an interior surface 533. The body 531 can include a first insulation layer 540, a second insulation layer 560, and an outer insulation layer 580, as well as a first shield layer 550 and a second shield layer 570. The first shield layer 550 can be a magnetic shield layer and include a magnetic material, such as magnetic particles suspended in a resin. The second shield layer 570 can include an electrically-conductive material.

In the non-limiting example shown, the set of conductors 520 includes a first conductor 521 and a second conductor 522, although any number of conductors can be provided. The first conductor 521 and the second conductor 522 are illustrated as wrapped with a respective first sheath 521S and second sheath 522S. Furthermore, the first conductor 521 and the second conductor 522 are shown as single-strand conductors in the illustrated example. It is contemplated that either or both of the first conductor 521 or the second conductor 522 can have multiple strands in some implementations.

One difference compared to the electrical components 100, 200, 300, 400 is that the shield assembly 530 can include an interior gap defining a cooling passage. In the non-limiting example shown, the second shield layer 570 is spaced from the outer insulation layer 580 to define a cooling passage 585. The cooling passage 585 can extend in any suitable direction, including axially along the shield assembly 530, radially within the shield assembly 530, circumferentially about the shield assembly 530, or combinations thereof. In this manner, the cable 510 can operate in higher-temperature environments with the cooling performance of the cooling passage 585 combined with the thermal management benefits provided by the first and second shield layers 550, 570.

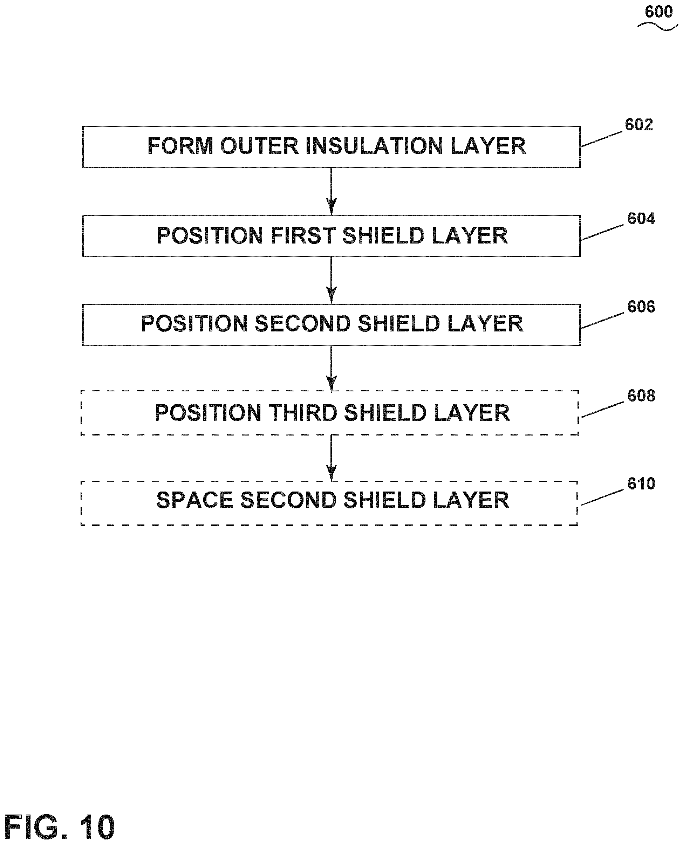

Referring now to FIG. 10, a flowchart illustrates a method 600 of forming a shield assembly, such as the shield assembly 130, 230, 330, 430, 530. The method 600 at 602 includes forming an outer insulation layer, such as the outer insulation layer 180, 280, 380, 480, 580, extending along an axial direction and bounding an interior configured to receive a set of electrical conductors, such as the set of conductors 120, 220, 320, 420, 520. The method 600 includes at 604 positioning a first shield layer, such as the first shield layer 150, 250, 350, 450, 550, radially inward of the outer insulation layer, with the first shield layer comprising magnetic particles suspended in a resin. The method 600 also includes at 606 positioning a second shield layer, such as the second shield layer 170, 270, 370, 470, 570, spaced radially from the first shield layer, with the second shield layer comprising an electrically-conductive material.

Optionally, the method 600 can include at 608 positioning a third shield layer, such as the third shield layer 390, 490, radially inward of the outer insulation layer, with the third shield layer comprising an additional electrically-conductive material. Optionally, the method 600 can include at 610 spacing the second shield layer, such as the second shield layer 570, from the outer insulation layer to define a cooling passage, such as the cooling passage 585, extending axially along the shield assembly.

Aspects of the disclosure provide for several benefits. The use of magnetic particles or powders in the first shield layer provides for shielding induced flux of electrical components, including AC cables or HVAC cables, while minimizing induced-current and hysteresis losses at high-frequency excitation. Furthermore, extra losses in the electrically-conductive shielding layer(s) can be reduced significantly due to induced flux density reduction enclosed by the first shield layer. The combination of electrically-conductive layers and magnetic flux-shaping layers can achieve high EMI performance and low shielding losses, which leads to improvements in overall cable current density and efficiency.

To the extent not already described, the different features and structures of the various aspects can be used in combination with each other as desired. That one feature cannot be illustrated in all of the aspects is not meant to be construed that it cannot be, but is done for brevity of description. Thus, the various features of the different aspects can be mixed and matched as desired to form new aspects, whether or not the new aspects are expressly described. Combinations or permutations of features described herein are covered by this disclosure.

This written description uses examples to disclose aspects of the disclosure, including the best mode, and also to enable any person skilled in the art to practice aspects of the disclosure, including making and using any devices or systems and performing any incorporated methods. The patentable scope of the disclosure is defined by the claims, and can include other examples that occur to those skilled in the art. Such other examples are intended to be within the scope of the claims if they have structural elements that do not differ from the literal language of the claims, or if they include equivalent structural elements with insubstantial differences from the literal languages of the claims.

Further aspects of the present disclosure are provided by the subject matter of the following clauses:

An electrical component, comprising: a set of electrical conductors extending along an axial direction; and a shield assembly with a body at least partially encircling the set of electrical conductors and defining a radial direction orthogonal to the axial direction, the shield assembly comprising: a first shield layer comprising magnetic particles suspended in a resin; and a second shield layer spaced from the first shield layer and comprising an electrically-conductive material.

The electrical component of any preceding clause, further comprising a third shield layer comprising an additional electrically-conductive material.

The electrical component of any preceding clause, wherein the third shield layer is positioned radially between the first shield layer and the second shield layer.

The electrical component of any preceding clause, wherein at least one of the first shield layer or the second shield layer comprises multiple discrete segments.

The electrical component of any preceding clause, wherein the multiple discrete segments are arranged along at least one of the axial direction or the radial direction.

The electrical component of any preceding clause, further comprising an outer insulation layer at least partially defining an exterior surface of the shield assembly.

The electrical component of any preceding clause, wherein one of the first shield layer or the second shield layer is spaced from the outer insulation layer to define a cooling passage within the shield assembly.

The electrical component of any preceding clause, wherein the first shield layer is arranged to abut the outer insulation layer.

The electrical component of any preceding clause, wherein the set of electrical conductors, the first shield layer, and the second shield layer at least partially define an electrical cable extending between a first end and a second end.

The electrical component of any preceding clause, wherein the magnetic particles have a relative permeability (*µ*ᵣ) between 1-200 and a magnetic saturation level between 1-1.5 T.

The electrical component of any preceding clause, wherein the magnetic particles comprise ferrite powder, and the resin comprises an epoxy resin.

The electrical component of any preceding clause, wherein the electrically-conductive material comprises copper.

The electrical component of any preceding clause, wherein the additional electrically-conductive material comprises copper.

The electrical component of any preceding clause, wherein the electrically-conductive material comprises the additional electrically-conductive material.

The electrical component of any preceding clause, wherein the electrical cable defines a cable length between the first end and the second end, and the first shield layer defines a first axial length between 20-100% of the cable length.

The electrical component of any preceding clause, wherein the set of electrical conductors comprises three electrical conductors configured to provide three-phase alternating-current power.

The electrical component of any preceding clause, wherein at least one of the first shield layer or the second shield layer is coupled to the interior surface of the outer insulation layer.

The electrical component of any preceding clause, further comprising a third shield layer comprising an additional electrically-conductive material.

The electrical component of any preceding clause, wherein at least one of the first shield layer or the second shield layer comprises multiple discrete segments.

The electrical component of any preceding clause, wherein at least one of the first shield layer, the second shield layer, or the third shield layer comprises multiple discrete segments.

A shield assembly, comprising: a body with an exterior surface opposite an interior surface, with the interior surface bounding an interior configured to receive a set of electrical conductors; a first shield layer disposed within the interior and comprising magnetic particles suspended in a resin; and a second shield layer disposed within the interior, spaced from the first shield layer, and comprising an electrically-conductive material.

The shield assembly of any preceding clause, wherein the second shield layer at least partially surrounds the first shield layer.

The shield assembly of any preceding clause, further comprising a third shield layer disposed within the interior and comprising an additional electrically-conductive material.

The shield assembly of any preceding clause, wherein the third shield layer is positioned radially between the first shield layer and the second shield layer.

The shield assembly of any preceding clause, wherein the second shield layer is positioned radially inward of the first shield layer.

The shield assembly of any preceding clause, wherein at least one of the first shield layer or the second shield layer is spaced from the interior surface of the body to define a cooling passage within the shield assembly.

The shield assembly of any preceding clause, wherein at least one of the first shield layer or the second shield layer comprises multiple discrete segments.

The shield assembly of any preceding clause, wherein the multiple discrete segments are arranged along at least one of the axial direction or the radial direction.

The shield assembly of any preceding clause, further comprising an outer insulation layer at least partially defining the exterior surface.

The shield assembly of any preceding clause, wherein one of the first shield layer or the second shield layer is spaced from the outer insulation layer to define a cooling passage within the shield assembly.

The shield assembly of any preceding clause, wherein the first shield layer is arranged to abut the outer insulation layer.

The shield assembly of any preceding clause, wherein the set of electrical conductors, the first shield layer, and the second shield layer at least partially define an electrical cable extending between a first end and a second end.

The shield assembly of any preceding clause, wherein the magnetic particles have a relative permeability (*µ*ᵣ) between 1-200 and a magnetic saturation level between 1-1.5 T.

The shield assembly of any preceding clause, wherein the magnetic particles comprise ferrite powder, and the resin comprises an epoxy resin.

The shield assembly of any preceding clause, wherein the electrically-conductive material comprises copper.

The shield assembly of any preceding clause, wherein the additional electrically-conductive material comprises copper.

The shield assembly of any preceding clause, wherein the electrically-conductive material comprises the additional electrically-conductive material.

The shield assembly of any preceding clause, wherein the electrical cable defines a cable length between the first end and the second end, and the first shield layer defines a first axial length between 20-100% of the cable length.

The shield assembly of any preceding clause, wherein the set of electrical conductors comprises three electrical conductors configured to provide three-phase alternating-current power.

The shield assembly of any preceding clause, wherein at least one of the first shield layer or the second shield layer is coupled to the interior surface of the body.

The shield assembly of any preceding clause, further comprising a third shield layer comprising an additional electrically-conductive material.

The shield assembly of any preceding clause, wherein at least one of the first shield layer or the second shield layer comprises multiple discrete segments.

The shield assembly of any preceding clause, wherein at least one of the first shield layer, the second shield layer, or the third shield layer comprises multiple discrete segments.

A method of forming a shield assembly, the method comprising: forming an outer insulation layer extending along an axial direction and bounding an interior configured to receive a set of electrical conductors; positioning a first shield layer radially inward of the outer insulation layer, with the first shield layer comprising magnetic particles suspended in a resin; and positioning a second shield layer spaced radially from the first shield layer, with the second shield layer comprising an electrically-conductive material.

The method of any preceding clause, further comprising positioning a third shield layer radially inward of the outer insulation layer, with the third shield layer comprising an additional electrically-conductive material.

The method of any preceding clause, further comprising spacing the second shield layer from the outer insulation layer to define a cooling passage extending axially along the shield assembly.

An electrical component, comprising: a set of electrical conductors extending along an axial direction; and a shield assembly with a body at least partially encircling the set of electrical conductors and defining a radial direction orthogonal to the axial direction, the shield assembly comprising: a first shield layer comprising magnetic particles suspended in a resin; and a second shield layer comprising an electrically-conductive material.

The electrical component of any preceding clause, further comprising a third shield layer comprising an additional electrically-conductive material.

The electrical component of any preceding clause, wherein the third shield layer is positioned radially between the first shield layer and the second shield layer.

The electrical component of any preceding clause, wherein at least one of the first shield layer or the second shield layer comprises a plurality of discrete segments arranged along at least one of the axial direction or the radial direction.

The electrical component of any preceding clause, further comprising an outer insulation layer at least partially defining an exterior surface of the shield assembly.

The electrical component of any preceding clause, wherein one of the first shield layer or the second shield layer is spaced from the outer insulation layer to define a cooling passage within the shield assembly.

The electrical component of any preceding clause, wherein the first shield layer is arranged to abut the outer insulation layer.

The electrical component of any preceding clause, wherein the set of electrical conductors, the first shield layer, and the second shield layer at least partially define an electrical cable extending between a first end and a second end.

The electrical component of any preceding clause, wherein the magnetic particles have a relative permeability (*µ*ᵣ) between 1-200 and a magnetic saturation level between 1-1.5 T.

A shield assembly, comprising: a body with an exterior surface opposite an interior surface, with the interior surface bounding an interior configured to receive a set of electrical conductors; a first shield layer disposed within the interior and comprising magnetic particles suspended in a resin; and a second shield layer disposed within the interior and comprising an electrically-conductive material.

The shield assembly of any preceding clause, wherein the second shield layer at least partially surrounds the first shield layer.

The shield assembly of any preceding clause, further comprising a third shield layer disposed within the interior and comprising an additional electrically-conductive material.

The shield assembly of any preceding clause, wherein the third shield layer is positioned radially between the first shield layer and the second shield layer.

The shield assembly of any preceding clause, wherein the second shield layer is positioned radially inward of the first shield layer.

The shield assembly of any preceding clause, wherein at least one of the first shield layer or the second shield layer is spaced from the interior surface of the body to define a cooling passage within the shield assembly.

The shield assembly of any preceding clause, wherein the second shield layer comprises a set of discrete segments.

The shield assembly of any preceding clause, wherein the magnetic particles have a relative permeability (*µ*ᵣ) between 1-200 and a magnetic saturation level between 1-1.5 T.

A method of forming a shield assembly, the method comprising: forming an outer insulation layer extending along an axial direction and bounding an interior configured to receive a set of electrical conductors; positioning a first shield layer radially inward of the outer insulation layer, with the first shield layer comprising magnetic particles suspended in a resin; and positioning a second shield layer spaced radially from the first shield layer, with the second shield layer comprising an electrically-conductive material.

The method of any preceding clause, further comprising positioning a third shield layer radially inward of the outer insulation layer, with the third shield layer comprising an additional electrically-conductive material.

The method of any preceding clause, further comprising spacing the second shield layer from the outer insulation layer to define a cooling passage extending axially along the shield assembly.

## Claims

1. An electrical component (100, 200, 300, 400, 500), comprising:
a set of electrical conductors (120, 220, 320, 420, 520) extending along an axial direction (A); and
a shield assembly (130, 230, 330, 430, 530) with a body (131, 231, 331, 431, 531) at least partially encircling the set of electrical conductors (120, 220, 320, 420, 520) and defining a radial direction (R) orthogonal to the axial direction, the shield assembly (130, 230, 330, 430, 530) comprising:
a first shield layer (150, 250, 350, 450, 550) comprising magnetic particles suspended in a resin; and
a second shield layer (170, 270, 370, 470, 570) comprising an electrically-conductive material.

2. The electrical component (100, 200, 300, 400, 500) of claim 1, further comprising a third shield layer (190, 390, 490) comprising an additional electrically-conductive material.

3. The electrical component (100, 200, 300, 400, 500) of claim 2, wherein the third shield layer (190, 390, 490) is positioned radially between the first shield layer (150, 250, 350, 450, 550) and the second shield layer (170, 270, 370, 470, 570).

4. The electrical component (100, 200, 300, 400, 500) of any preceding claim, wherein at least one of the first shield layer (150, 250, 350, 450, 550) or the second shield layer (170, 270, 370, 470, 570) comprises a plurality of discrete segments arranged along at least one of the axial direction (A) or the radial direction (R).

5. The electrical component (100, 200, 300, 400, 500) of any preceding claim, further comprising an outer insulation layer (180, 280, 380, 480, 580) at least partially defining an exterior surface (132, 232, 332, 432, 532) of the shield assembly (130, 230, 330, 430, 530).

6. The electrical component (100, 200, 300, 400, 500) of claim 5, wherein one of the first shield layer (150, 250, 350, 450, 550) or the second shield layer (170, 270, 370, 470, 570) is spaced from the outer insulation layer (180, 280, 380, 480, 580) to define a cooling passage (585) within the shield assembly (130, 230, 330, 430, 530).

7. The electrical component (100, 200, 300, 400, 500) of claim 5, wherein the first shield layer (150, 250, 350, 450, 550) is arranged to abut the outer insulation layer (180, 280, 380, 480, 580).

8. The electrical component (100, 200, 300, 400, 500) of any preceding claim, wherein the set of electrical conductors (120, 220, 320, 420, 520), the first shield layer (150, 250, 350, 450, 550), and the second shield layer (170, 270, 370, 470, 570) at least partially define an electrical cable (110, 210, 310, 410, 510) extending between a first end and a second end.

9. The electrical component (100, 200, 300, 400, 500) of any preceding claim, wherein the magnetic particles have a relative permeability (*µ*ᵣ) between 1-200 and a magnetic saturation level between 1-1.5 T.

10. A shield assembly (130, 230, 330, 430, 530), comprising:
a body (131, 231, 331, 431, 531) with an exterior surface (132, 232, 332, 432, 532) opposite an interior surface (133, 233, 333, 433, 533), with the interior surface (133, 233, 333, 433, 533) bounding an interior (135) configured to receive a set of electrical conductors (120, 220, 320, 420, 520);
a first shield layer (150, 250, 350, 450, 550) disposed within the interior (135) and comprising magnetic particles suspended in a resin; and
a second shield layer (170, 270, 370, 470, 570) disposed within the interior (135) and comprising an electrically-conductive material.

11. The shield assembly (130, 230, 330, 430, 530) of claim 10, wherein the second shield layer (170, 270, 370, 470, 570) at least partially surrounds the first shield layer (150, 250, 350, 450, 550).

12. The shield assembly (130, 230, 330, 430, 530) of claim 10 or 11, further comprising a third shield layer (190, 390, 490) disposed within the interior (135) and comprising an additional electrically-conductive material.

13. The shield assembly (130, 230, 330, 430, 530) of claim 12, wherein the third shield layer (190, 390, 490) is positioned radially between the first shield layer (150, 250, 350, 450, 550) and the second shield layer (170, 270, 370, 470, 570).

14. The shield assembly (130, 230, 330, 430, 530) of any of claims 10 to 13, wherein the second shield layer (170, 270, 370, 470, 570) is positioned radially inward of the first shield layer (150, 250, 350, 450, 550).

15. The shield assembly (130, 230, 330, 430, 530) of any of claims 10 to 14, wherein at least one of the first shield layer (150, 250, 350, 450, 550) or the second shield layer (170, 270, 370, 470, 570) is spaced from the interior surface of the body (131, 231, 331, 431, 531) to define a cooling passage (585) within the shield assembly (130, 230, 330, 430, 530).
